# EUROPEAN PATENT APPLICATION

(11) **EP 2 735 378 A1**
(43) Date of publication of application: **28.05.2014**
(21) Application number: 12194116.5
(22) Date of filing: 23.11.2012
(51) Int. Cl.: B05D 1/30, B32B 37/12, C03C 17/32, H01L 31/048, B32B 17/10

(54) **Method for making a solar module with encapsulant and system therefor**

(71) Applicant: 3S Swiss Solar Systems AG, 3250 Lyss (CH)
(72) Inventor: Söderström, Thomas, 1025 St-Sulpice (CH)
(74) Representative: Patentbüro Paul Rosenich AG

(57) **Abstract**

Multi-layer stacked modules such as modules with active electronic components such as solar modules (1) are described as well as methods of making the same and apparatus for manufacture of such modules.

A system and method for preparing elements of a solar module are described adapted for
holding a first layer (2) (e.g. glass substrate or back sheet with or without integrated electronic active devices such as solar cells (3)), preferably vertically, so that it is flat, and
a blade or squeegee (20) (e.g. having a reservoir for containing fluid encapsulant) used to apply the fluid to the first layer (2), the blade defining a gap to the outer layer.

## Description

The present invention relates to multi-layer stacked modules such as modules with active electronic components such as solar modules, methods of making the same and apparatus for manufacture of such modules.

### Background

Solar cell (photovoltaic) modules are typically constructed as a laminate with at least five layers: (a) glass layer, (b) a first or front encapsulant layer, (c) the solar cell layer, (d) a second or back encapsulant layer, and (e) a back layer such as a back sheet or a glass layer. The manufacturing method of laminated solar cell modules generally involves placing a piece of encapsulant foil between the solar cell(s) and the other module layers, such as the glass layer and the back- layer. The state of the art uses foils of 400-500 mu. The encapsulant layers are designed to encapsulate and protect the brittle solar cell layers from environmental damage and therefore prolong their useful life. Generally, a solar cell module will incorporate at least two encapsulant layers sandwiched around the solar cell layer. The two encapsulant layers can be the same or different materials. The optical properties of the front encapsulant layer should be such that light can be effectively transmitted to the solar cell layer whereas the back encapsulant layer can be reflective. Encapsulant layers can, for example, be made of polyvinyl butyral (PVB); thermoplastic polyurethane (TPU); ethylene copolymers such as ethylene vinyl acetate (EVA); ethylene copolymers which incorporate acid functionality, such as poly(ethylene-co-(meth)acrylic acid), and ionomers formed therefrom; silicone polymers; polyolefin and polyvinyl chloride (PVC).

Various polyester films, such as bi-axially-oriented poly(ethylene terephthalate) films, have been increasingly used in solar cell modules. The polyester films may serve as back-sheets or as dielectric layers between the solar cell and the back-sheet. If desired, the polyester film may be coated. For example, the coating may function as oxygen and moisture barrier.

Nowadays the encapsulant is usually placed in the lay-up for a solar module as a foil before lamination. WO2011089473 discloses the laminating process of a solar panel in detail. The foil has to be cut, handled and placed correctly on the lay-up. Since modules are quite large this is cumbersome. Also the foil has to be placed in the lay-up correctly and may not shift. In a lay-up consisting of 2 such foils, cells, glass and a back sheet, this may go wrong resulting in economic loss.

Also foils shrink during lamination. This is due to the production process of the foil. Moreover, it results from liquefying polymer granules and turning that into foil.

For both these reasons (alignment and shrinkage), the foils need to be made bigger than the final module. After lamination the foil (or what is left of it, a sticky mass) sticks out of the module and has to be removed what is not easy until the encapsulant becomes hard after a while, prolonging processing time. Also as long as the protruding foil is soft, it sticks to machine parts such as the conveyer belt it lays on and the membrane used for pressing it together that thus have to be cleaned regularly. Brushes can be provided for this purpose.

### Summary of the Invention

An object of embodiments of the present invention is to reduce or prevent the loss of encapsulant during assembly and manufacture and hence to reduce the material and manufacturing cost of a multi-layered stacked module such as a solar module. An advantage of embodiments of the present invention is that when only the amount of encapsulant finally required for the module is used in the lamination process, costs can be saved. Also the pre-lamination step of making the polymer granules into a foil can be omitted, further reducing costs. An advantage of embodiments of the present invention is that a way of providing an encapsulant to the lay-up is disclosed at just the right amount and in the right place. Further, an advantage of embodiments is that machine tools getting dirty and the need to be cleaned can be avoided, which increases the uptime of the machines.

The present invention includes in some embodiments a system for preparing elements of a solar module comprising:
means for holding a first layer (e.g. glass substrate or back layer such as a back sheet with or without integrated electronic active devices such as solar cells), preferably vertically, so that it is flat, and
a blade or squeegee (e.g. having a reservoir or supply for containing a fluid encapsulant) used to apply a fluid encapsulant to the first layer, the blade defining a gap to the outer layer.

In any of the embodiments of the present invention the encapsulant can be applied to a substrate in a thickness in the range of 50-500 microns.

The system is suitable for the processing of solar cells inserted in the module or of thin film solar cells in which the active components, e.g. solar cells are deposited on a substrate, i.e. are integrated with the substrate.

The means for holding may include a suction wall or other holding structure. The reservoir may be a trough with side walls and the blade on one side. The trough may be tiltable to change the amount of liquid encapsulant that reaches the blade. The trough may include a heater.

In any of the embodiments, e.g. where encapulant material is used that becomes fluid by raising its temperature, preferably means are provided such as a heater and a control system to maintain the temperature of the encapsulant in the reservoir so that the encapsulant can be applied with a viscosity of 5 to 50 Poise to the substrate during the coating.

Preferably means are provided for relative motion between the substrate and the blade. The substrate may be held stationary during this motion.

Means for tilting the reservoir during the application of the coating may be provided.

The present invention also provides a method for laminating a solar module having a first outer layer (e.g. a glass substrate or a polymer sheet of some sort), the method comprising:
holding the first layer (e.g. glass substrate or back layer such as a back sheet with or without integrated electronic active devices such as solar cells), preferably vertically, so that it is flat, and
coating an encapsulant fluid from a reservoir to the first layer over a blade, the blade defining a gap to the outer layer,
forming the coated first layer into a lay-up and
laminating the lay-up to form a solar module.

The method may include the steps of:
- placing active elements (e.g. solar cells of any type: thin-film or crystalline or polycrystalline or amorphous) on the encapsulant coating of the first outer layer;
- placing a second outer layer (e.g. a glass substrate or a back layer such as a back sheet) with encapsulant (e.g. a foil or also coating according to other embodiments of the present invention) on the active elements to form a lay-up; and
- laminating the lay-up to form a solar module.

The coating is made by relative motion between the substrate and the blade. The substrate may be held stationary. In any of the embodiments of the present invention the encapsulant can be applied to a substrate in a thickness in the range of 50-500 microns.

The method may also include the step of tilting the reservoir during the application of the coating.

The method is suitable for the processing of thin film solar cells.

In any of the embodiments e.g. where the encapsulant is made liquid by raising its temperature, the temperature of the encapsulant in the reservoir is maintained so that the encapsulant can be applied with a viscosity of 5 to 50 Poise to the substrate being coated.

### Brief Description of the Drawings

Fig. 1a shows schematically a solar module of a type described with respect to the present invention.
Fig. 1b shows schematically a solar module of a type described with respect to the present invention in exploded view.
Fig. 2 shows schematically a solar module of a type described with respect to the present invention after lamination.
Fig. 3 shows schematically a section through a laminator of solar modules prior to lamination.
Figs. 4 and 5 show schematically a section through a laminator of solar modules after lamination.
Fig. 6 shows a flow diagram of a method of manufacture according to an embodiment of the present invention.
Fig. 7 shows a further flow diagram of a method of manufacture according to an embodiment of the present invention.
Fig. 8 shows yet another flow diagram of a method of manufacture according to an embodiment of the present invention.
Fig. 9 shows a coating method and apparatus according to an embodiment of the present invention.
Figs. 10 and 11 show details of a coating method and apparatus according to an embodiment of the present invention.
Figs. 12 and 13 show details of a support means according to embodiments of the present invention.
Figs. 14 and 15 show further details of a support means according to embodiments of the present

### Definitions

An encapsulant is any material used to hold together the sandwich of first outer layer which will form the front or top layer in the final product (e.g. normally glass) and a back layer such as a back sheet and further elements between them). Normally an encapsulant layer is placed between any two layers that do not adhere to each other themselves.

A stentering frame is a frame used for tensioning a foil, in laminators the membrane.

The term "thin-film" with reference to solar cells is derived from the method used to deposit the film, not from the thickness of the film. Thin-film cells are deposited in very thin, consecutive layers of atoms, molecules, or ions. The active area is usually only 1 to 10 microns thick (thick-films typically are as much as 200 to 400 microns thick). Thin-film cells are also usually amenable to large-area fabrication and are suitable for automated, continuous production, arraying, and packaging. They can also be deposited on flexible substrates. A variety of semiconductor materials have appropriate energy band gaps and absorption characteristics such as amorphous silicon (a-Si), copper indium gallium diselenide (CIGS), Gallium Arsenide, (GaAs), Kesterite (CZTS, CZTSe) and cadmium telluride (CdTe).

### Description of the preferred embodiments

The present invention will be described with respect to particular embodiments and with reference to certain drawings but the invention is not limited thereto but only by the claims.

The present invention relates to methods or systems for coating of flat objects especially the coating of transparent flat objects. In particular the present invention relates to methods or systems of coating of transparent, flat, form stable but (e.g. slightly) flexible objects or stiff and rigid objects. The present invention relates to methods or systems for laminating of sandwiched bodies, more particular the lamination of solar modules. The present invention relates in particular to methods and systems for the lamination of sandwiched bodies such as solar modules with an encapsulant whereby the encapsulant is coated onto the any of the flat objects mentioned above. The encapsulant can be a thermosetting encapsulant, one component or two component encapsulant or a thermoplast encapsulant.

The material for encapsulating the photocell wafers preferably provides electrical insulation of the wafers and connecting circuitry, mechanical protection for the wafer themselves, corrosion protection for the metal contacts, and physical integrity of the circuitry and photocell assembly over an economically useful life of the assembly (usually 20 years in the case of roof-top solar panels). More specifically, the encapsulant material for the front side is preferably highly transparent and light-transmissive, and/or electrically insulating, and/or should be sufficiently soft to cushion the photocell layers (thin film) or wafers and/or to dampen vibration, and/or should preferably protect the cells from stresses due to thermal expansion differences and external impact, and/or preferably has oxidative, hydrolytic and other chemical stability, and/or preferably has good adhesive properties. If the photocell assemblies are used in environments subject to changing conditions of temperature and weather, the encapsulant should preferably have a glass transition temperature (Tg) close to or below the lowest temperature extreme which the module might experience, and/or should preferably also exhibit little or no significant mechanical creep at upper operating temperature extremes so that the laminar assembly will remain intact. Accordingly, for most rooftop solar cell applications and similar applications subject to the elements in northerly regions of the western hemisphere, the glass transition temperature should preferably be below about - 10 DEG C or down to -40 DEG C. and ideally no significant mechanical creep should be experienced within the completed module up to a maximum operating temperature which will depend upon the geographic location.

Additional considerations in selecting an effective photocell encapsulant include melt viscosity/temperature relationship, and/or the speed and ease with which photocell assemblies may be produced, and/or the capability of recycling scrap material. Concerning melt viscosity/temperature relationship, photocell assemblies are commonly produced by vacuum lamination in which the steeper the melt viscosity/ temperature curve for the encapsulant the greater the ease of processing. The encapsulant material, whether sheet or coating, is preferably dry and non-tacky by the time of the initial evacuation step so as not to entrap air between the layers. However, the encapsulant should be liquid e.g. melt during the lamination to provide sufficient fluidity for penetration and wetting of all the irregularities of the cell circuit.

Chemically, the encapsulant may be such as a one component or two or multi-component silicone, silicone polymer, silicone thermoplastic or polyvinyl butyral (PVB); polyethylene (PE), thermoplastic polyurethane (TPU); ethylene copolymers such as ethylene vinyl acetate (EVA); ethylene copolymers which incorporate acid functionality, such as poly(ethylene-co-(meth)acrylic acid), polyolefin, thermoplastic polyolefin (TPO), thermoplastic silicone, ionomers, and polyvinyl chloride (PVC)

The present invention also relates to the laminated solar panel made by any of the methods of the present invention. In some embodiments of the present invention the process of liquefying encapsulant directly is used for coating which circumvents the additional step of forming a foil or sheet. The liquefaction can be by rising the temperature of the encapsulant material or the encapsulant can be liquid at room temperature or at the application temperature such as by using a liquid radiation crosslinked system or by using a liquid multi-component system.

Various polyester films, such as bi-axially-oriented poly(ethylene terephthalate) films, have been increasingly used in solar cell modules. The polyester films may serve as back layers such as a back sheets or as dielectric layers between the solar cell and the back-sheet. If desired, the polyester film may be coated. For example, the coating may function as an oxygen and moisture barrier.

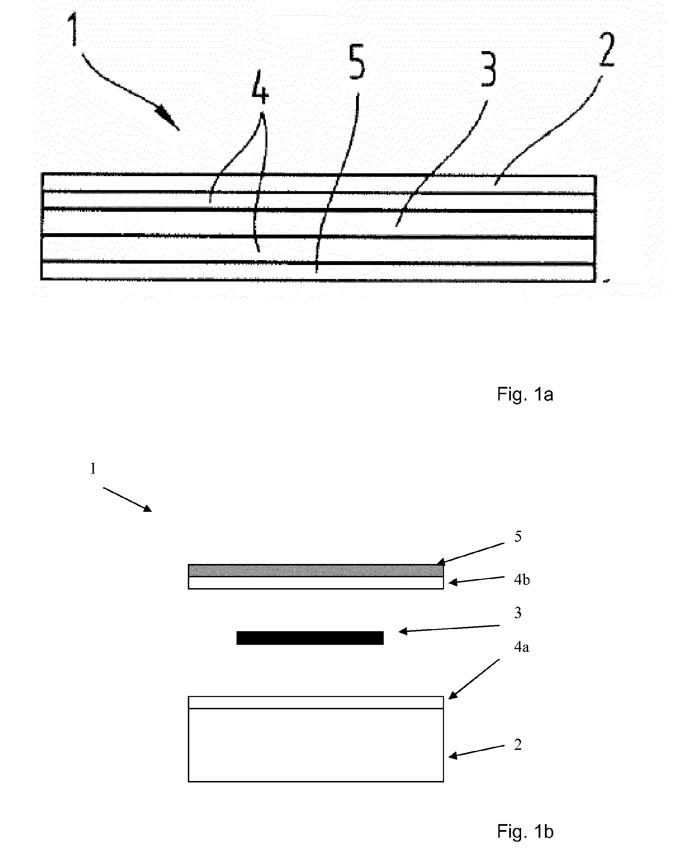

A solar module 1 of one types included within the scope of the present invention is shown schematically in Fig. 1a.

Sandwiched bodies such as solar modules e.g. according to embodiments of the present invention, are built up of multiple layers that are joined together under the influence of heat and pressure by lamination. Referring to Fig. 1a, when laminating a solar module 1, a lay-up of the following materials is made: front glass 2, an encapsulant layer 4, an active layer (e.g. a matrix of solar cells) 3, a further encapsulant 4 and a back layer such as a back sheet (that may optionally be a glass plate) 5. In Fig. 1b a module of one embodiment is shown in an exploded view, i.e. not laminated and in the stage of being laid-up (not to scale).

In accordance with some embodiments of the present invention, a first layer e.g. coating 4a with adhesive properties, such as EVA, or PVB or silicone or any other suitable transparent thermoplastic or thermosetting material that is suitable as an encapsulant (for materials see above) is coated onto a transparent rigid plate such as a glass plate 2. At least one electronically active element such as a solar cell 3, typically maybe 6 x 10 cells connected in series, is/are incorporated on the glass plate and an encapsulant and/or the adhesive coating 4a is applied thereto or the one or more solar cells is/are placed on that encapsulant and/or adhesive coating 4a. Optionally, another layer, e.g. a second encapsulant and/or adhesive coating 4b, such as any of the encapsulant materials mentioned above such as EVA, or PVB or silicone or any other thermoplastic or thermosetting material is applied or formed onto to a back layer such as a back sheet 5. In other embodiments at least one electronic active element such as a solar cell 3, normally maybe 6 x 10 cells connected in series, is/are incorporated on the back sheet and the liquefied encapsulant applied thereto. Finally, the adhesive sheet forming the second layer and the back layer such as the back sheet 5 or the back layer such as the back sheet 5 with the coating 4b are placed on top of the solar cell 3. The back layer such as the back sheet 5 mainly serves the function of protecting the first coating and second layer or coating 4a, 4b and the solar cell 3 from environmental influences such as getting damp. The back layer such as the back sheet 5 can be built up from a polymer such as PVF or PET or polyamide or any other suitable polymer or combination thereof. Alternatively, the back sheet 5 can be formed by a glass plate, resulting in so called glass-glass modules.

The second layer or back sheet coating 4b can be transparent or coloured, e.g. it can be a clear or white solar PV encapsulant coating or sheet.. The solar module captures incident sunlight and also reflects a part of this light from the back sheet so that more sunlight reaches the solar cell layer.

The module may include additional layers such as one or more barrier layers, e.g. against oxygen or moisture migration or with optical properties such as photoluminescence or reflective pigments and (nano) particles.

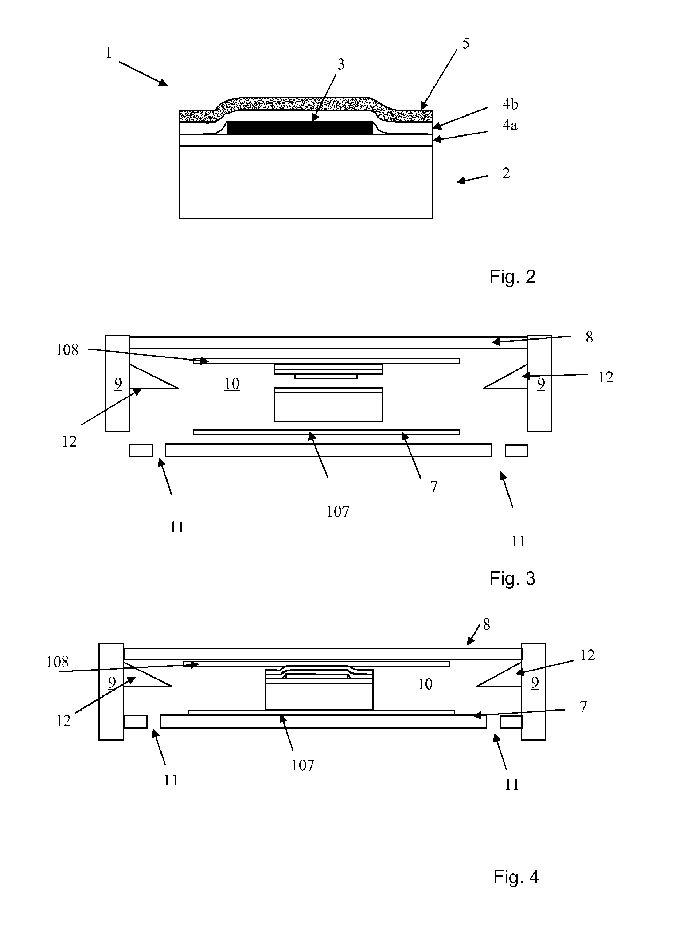

The assembled module or so called "lay-up" is fed into a laminator where it is heated and pressed together. For example, the lay-up can be placed on a heating plate 7 in the laminator (see Fig. 3 for further explanation). The glass plate 2 can lie directly on the heating plate 7 although a thin transport sheet 107 can be used for moving the lay-up into the laminator.

Once the lay-up has reached a certain temperature, say 90 degrees Celsius, a pressure is applied to the lay-up, pressing all layers together and deforming them (Fig. 2).

In accordance with the present invention the lamination process may be completed in any suitable laminator, that as such can be as known from the state of the art. Referring to Figs. 3 and 4, in one type of laminator, which can be used with the present invention, the pressure is applied by a membrane 8. The membrane 8, the heating plate 7 and the side walls 9 form a vacuum chamber 10. Optionally a release sheet 108 is placed between the membrane 8 and the module, so that materials from the modules that melt during lamination do not contaminate the membrane 8. Optionally, the modules are placed on a transport sheet 107 to move then into the laminator (Fig. 3) and the chamber is closed ready to pull vacuum (Fig. 4).

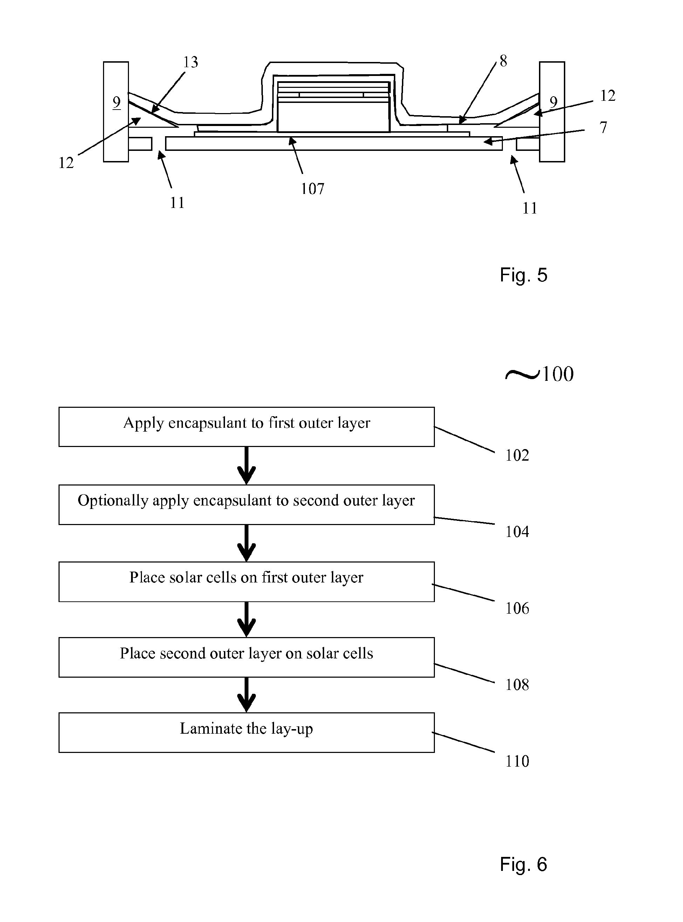

Once the lay-up is inside the chamber 10, the chamber is evacuated through the conduits 11. The atmospheric pressure on the top of the membrane 8 presses it down onto the lay-up, rendering an equally distributed pressure (see Fig. 5)

Note that the ends of the membrane are moved down together with the stentering frame 12.

Since the membrane 8 is heated up by the heating plate 7, it becomes more flexible and also expands due to heat expansion. Since the membrane should not fold otherwise it would cause crease imprints on the back sheet 5 or rip, the membrane is tensioned by the stentering frame 12. The slanting surface 13 of the stentering frame 12 compensates for the elongation of the membrane 8. Note that the stentering frame 12 leaves the conducts 11 open in order to allow evacuation of the chamber 10.

Before pressing the modules, the air between the layers of the modules should be evacuated as much as possible. This is can be done in the following way.

Referring to Fig. 6, a preferred embodiment of the present invention is a method 100 of forming an encapsulant film or coating on one side of a glass substrate or other substrate which will form an outer layer or layers of a solar module. The coating is in the form of an encapsulant, e.g. preferably having adhesive properties for gluing multiple layers of a stacked layer module construction together. Suitable materials for the encapsulant are described above. To provide this coating (step 102), the glass substrate or other substrate (optional step 104) is contacted with a liquid encapsulant. The substrate can be put in an inclined or more preferably vertical state and then contacted with the encapsulant liquid from a weir or squeegee provided to one side of a liquid encapsulant reservoir, e.g. in the form of a trough. For example, the encapsulant can be a liquid at room temperature that is applied as such and then converted into a solid when in the final product, e.g. by radiation or chemical crosslinking, or the liquid encapsulant can be formed by heating the encapsulant material until it is liquid and later cooling to solidify. A heater, additional thermal mass, insulation or any combination thereof may be provided in the trough to keep the encapsulant material at the correct temperature. Other methods of making a liquid encapsulant are mixing the two components of a 2k encapsulant and immediately applying it. Where necessary the equipment may include means for radiating the coated encapsulant, e.g. with ultra-violet light.

The coating is formed by relative displacement of the glass substrate or other substrate and the liquid dispenser. A defined slit with defined width is provided between the weir or edge of the squeegee and the glass substrate or other substrate. This slit, liquidity of the encapsulant and speed determine the thickness of the coating. The conversion of the liquid encapsulant to a solid may be performed by any suitable method, e.g. when the coating touches the substrate a process of cooling by exchange of heat energy with the substrate can begin thus solidifying the encapsulant material, or a process of hardening or cross-linking can begin e.g. by incident radiation or by chemical reaction with a hardner. Where appropriate, the holding means for the substrate may have heating or cooling means to solidify the encapsulant or keep it soft or means for irradiating. Note that in a 2k or thermosetting encapsulant heating will result in faster solidification while a thermoplastic material can be kept soft this way. Also for the adherence of the encapsulant, the substrate may be kept in a desired temperature range.

In any of the embodiments of the present invention the encapsulant can be applied to a substrate in a thickness in the range of 50-500 microns. In any of the embodiments the encapsulant can be used with a viscosity of 5 to 50 Poise during the application to the substrate.

The plate glass substrate or other substrate can be vertical or in an inclined state. To maintain a uniform and reproducible coating it is best that all conditions remain constant or as constant as it is possible to maintain, e.g. temperature, speed of the relative motion, the glass substrate is flat and is kept flat, the distance between the edge of the weir or squeegee and the glass substrate is kept constant. Note when the coating is applied on a vertical glass, the force of gravity will help to recycle the unused material into the reservoir.

After this coating step is carried out, a solar module is assembled, e.g. by first coating the glass, making a lay-up by applying the electronic active elements such as solar cells and optionally a further encapsumant layer and the back layer such as the back sheet (steps 106 and 108) and laminating (step 110) the solar module according to any of the methods described above and below. The lay-up comprises at least a coated glass plate and optionally a coated back sheet or second glass plate and the electronic active elements such as solar cells before curing. Other layers such as optical filters or barriers may also be included.

An advantage of embodiments of the present invention can be that not much material has to be stored in comparison to the storing of foils which have to be made in large quantities to be economical beforehand. An advantage of embodiments of the present invention can be that the encapsulant does not degrade or does not have to be stored in a special way to prevent degradation. The encapsulant and or out the layer(s) on which it has been applied may still be hot, enabling faster laminating.

To prevent that the coating step becomes a bottle neck of the production line, several coating machines may be used in parallel. As each is not expensive they can be duplicated easily. Encapsulant may be fragile. To improve the stability of the coating it can be allowed to cool or partially cross-link before the cells are placed on it. It is preferred if the encapsulant is not sticky to avoid that air may get trapped inside the module.

Another advantage of this method of providing one or more encapsulant layers is that while the coating machine is not expensive, a metered amount of encapsulant is applied in an easy fashion to exactly the right location. No encapsulant foil needs to be made or used. All together less work has to be done, e.g. no foil, no exact positioning, no cutting of the foil, and the process is more reliable as it requires less human intervention.

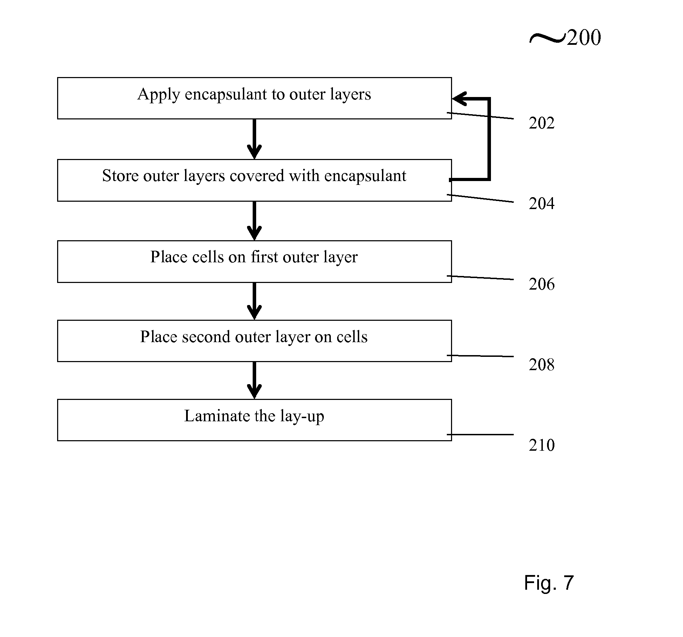

An alternative embodiment will be described with reference to Fig 7. In this embodiment a coated glass substrate is stored before use. For example, referring to Fig. 7, a further embodiment of the present invention is a method 200 of forming an encapsulant film or coating on one side of a glass substrate and another substrate which will form the outer layers of a solar module. The coating is in the form of an encapsulant, e.g. preferably having adhesive properties for wetting and gluing multiple layers of a stacked layer module construction together. Encapsulant materials are described above. To provide this coating (step 202) the glass substrate and other substrates such as the back layer such as the back sheet are contacted with a liquid encapsulant to form a coating on the substrate. The coated materials are then stored ready for later use (step 204). The coating step is repeated as often as necessary, e.g. to increase thickness or with other substrates. Optionally, the substrate such as the glass and the back layer such as the back sheet are put in an inclined or more preferably vertical state and contacted with the encapsulant liquid from a weir or squeegee provided to one side of a liquid encapsulant reservoir, e.g. in the form of a trough. The liquid can be preferably formed by heating the encapsulant material until it is liquid. Other methods of making a liquid encapsulant are mixing the two components of a 2k encapsulant and immediately applying it or applying a liquid encapsulant that is solidified by cross-linking with radiation e.g. UV. The coating is formed by relative displacement of the glass substrate or other substrate and the liquid dispenser. A defined slit with defined width is provided between the weir or edge of the squeegee and the glass substrate or other substrate. This slit determines thickness of the coating. When the coating touches the substrate a process of cooling by exchange of heat energy with the substrate begins thus solidifying the encapsulant material.

Also in this embodiment of the present invention the encapsulant can be applied to a substrate in a thickness in the range of 50-500 microns and the encapsulant can be used with a viscosity of 5 to 50 Poise during the application to the substrate.

The plate glass substrate or other substrate can be vertical or in an inclined state. To maintain a uniform and reproducible coating it is best that all conditions remain constant or as constant as is possible, e.g. temperature, speed of the relative motion, the glass substrate is flat and is kept flat, the distance between the edge of the weir or squeegee and the glass substrate is kept constant.

After this coating step is carried out a solar module is produced, e.g. by first coating the glass, making a lay-up by applying the electronic active elements such as the solar cells and the back layer such as the back sheet (steps 206 and 108) and laminating (step 210) the solar module according to any of the methods described above and below. The lay-up comprises at least a coated glass plate and optionally a coated back layer such as the back sheet or second glass plate and the electronic active elements such as solar cells before further processing. Other layers such as optical filters or barriers may also be included.

In comparison with the previous embodiment more completed material has to be stored, however, an advantage of this embodiment is that the coating step can be carried out off-line and hence will not become bottle neck of production line. A further advantage is that fragile encapsulant layers are allowed to cool and optionally partially to cross-link which makes the layer stronger for when the solar cells are placed on it. If sticky encapsulant is used air may get trapped inside the module. By storing the material for some time the tackiness may be reduced.

It can be an embodiment of the present invention to store the coated substrate in such a way that the encapsulant does not degrade, e.g. at a reduced temperature, in an atmosphere of reduced oxygen etc.

An advantage of this method of providing one or more encapsulant layers is also that the coating machine is not expensive and also a metered amount of encapsulant is applied in an easy fashion to exactly the right location. No encapsulant foil needs to be made or used. All together less work has to be done, e.g. no foil, no exact positioning, no cutting of the foil, and the process is more reliable as it requires less human intervention.

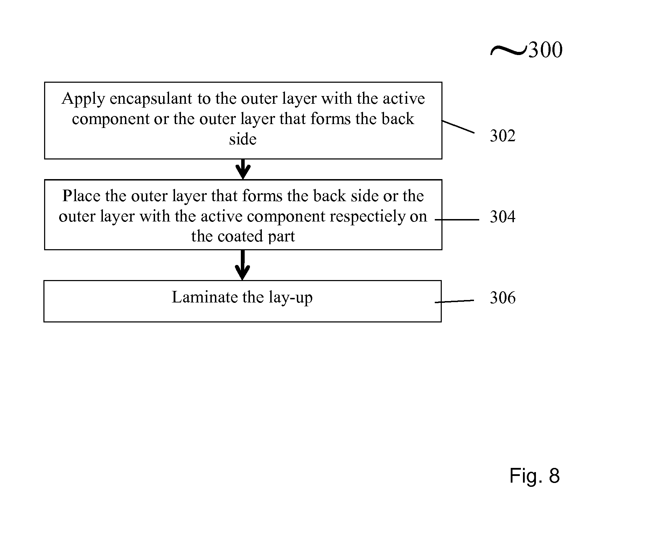

An alternative embodiment of the present invention will be described with reference to Fig. 8 to make a thin film solar module. Thin film solar cells are made on a glass plate: the glass is the substrate the semiconductor film is deposited on. Therefore the module has less loose components and is easier to make. Thin film is defined above.

Accordingly, referring to Fig. 8, yet a further embodiment of the present invention is a method 300 of forming an encapsulant film or coating on one side of a glass substrate or other substrate which will form an outer layer or layers of a solar module.

The coating is in the form of an encapsulant, e.g. preferably having adhesive properties for gluing multiple layers of a stacked layer module construction together. To provide this coating (step 202) the glass substrate or the other substrate already comprising pre-installed electronic active elements such as solar cells (e.g. thin film cells) is contacted with a liquid encapsulant. Suitable materials for the encapsulant have been described above. The substrate can be put in an inclined or more preferably vertical state and then contacted with the encapsulant liquid from a weir or squeegee provided to one side of a liquid encapsulant reservoir, e.g. in the form of a trough. The liquid can be preferably formed by heating the encapsulant material until it is liquid. A heater may be provided in the trough to keep the encapsulant material at the correct temperature. Other methods of making a liquid encapsulant are mixing the two components of a 2k encapsulant and immediately applying it. Alternatively a liquid encapsulant can be used that is cross-linked by radiation, e.g. by UV. The coating is formed by relative displacement of the glass substrate or other substrate and the liquid dispenser. A defined slit with defined width is provided between the weir or edge of the squeegee and the glass substrate or other substrate. This slit determines thickness of the coating. When the coating touches the substrate a process of cooling by exchange of heat energy with the substrate begins thus solidifying the encapsulant material.

Also in this embodiment of the present invention the encapsulant can be applied to a substrate in a thickness in the range of 50-500 microns. In any of the embodiments encapsulant can be used with a viscosity of 5 to 50 Poise during the application to the substrate..

The plate glass substrate or other substrate can be vertical or in an inclined state. To maintain a uniform and reproducible coating it is best that all conditions remain constant or as constant as is possible, e.g. temperature, speed of the relative motion, the glass substrate is flat and is kept flat, the distance between the edge of the weir or squeegee and the glass substrate is kept constant. Even glass has manufacturing tolerances (thickness and shape) in the range of the thickness of the encapsulant coating, meaning that optionally glass can be flattened in order to get a defined thickness of the coating.

After this coating step is carried out a solar module is produced, e.g. by first coating the glass, and the solar cells and/or the back layer such as the back sheet with solar cells (step 302), making a lay-up by applying the other of the outer substrates (step 304) and laminating (step 306) the solar module according to any of the methods described above and below. The lay-up comprises at least a coated glass plate and optionally a coated back sheet or second glass plate and the solar cells incorporated therein before curing. Other layers such as optical filters or barriers may also be included.

A specific embodiment of means and method for applying the fluid encapsulant will now be described. In this preferred embodiment, the liquid encapsulant is applied only by a doctor blade or squeegee to the glass substrate 2 or the back layer such as the back sheet 5 or both. Suitable encapsulant materials have been described above. The glass substrate or optionally the back layer such as the back sheet may be held stationary by means for holding the substrate 24 and the weir or squeegee 20 moved over the substrate or vice versa. In either case it is necessary to hold the glass substrate or back layer such as the back sheet firmly and in a flat condition. If it is moved it should be guided uniformly. The liquid encapsulant is preferably applied while the glass or back back layer such as the back sheet is held vertically (to reduce foot print) but it can be inclined. This has also the unique advantage to use gravity to recycle the material in the reservoir and avoid spilling of material.

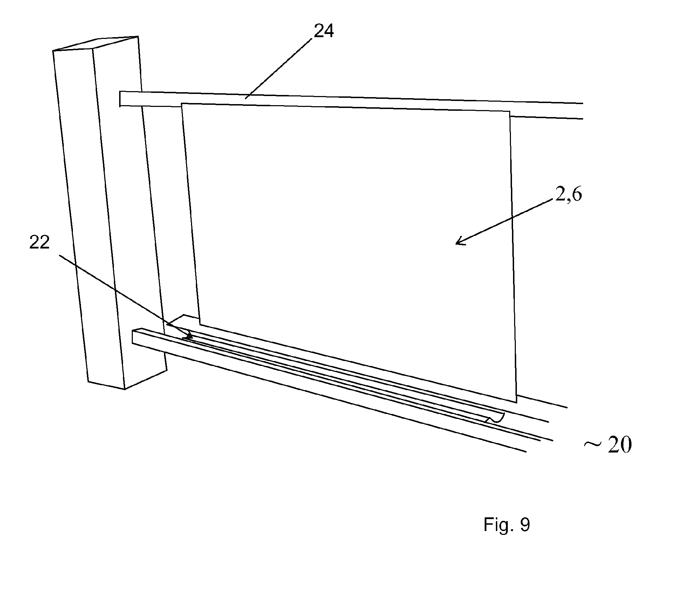

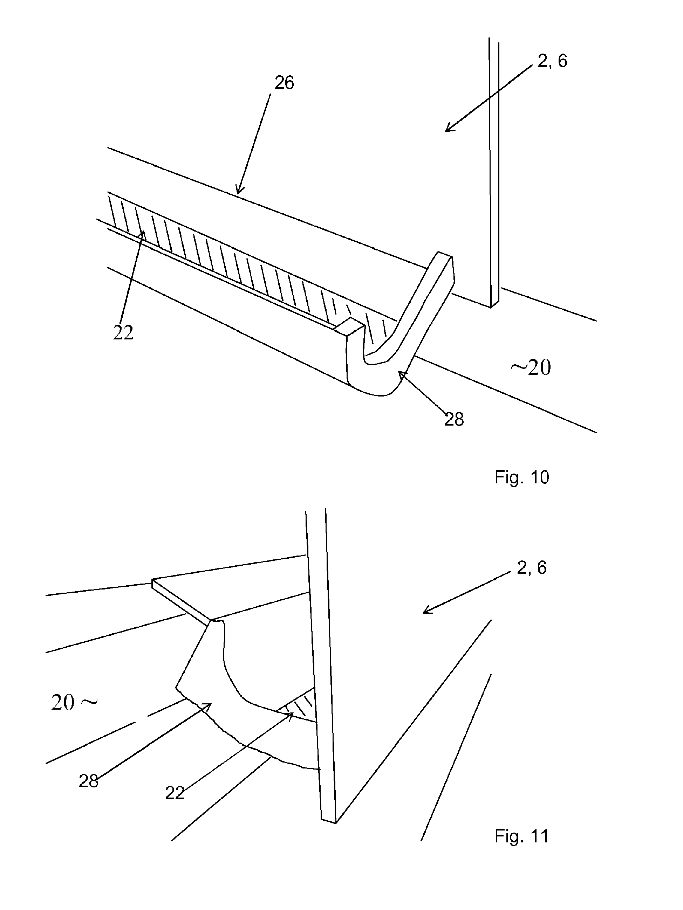

The means for applying the fluid encapsulant comprises a squeegee 20 with a reservoir or trough 22, a doctoring blade or edge 26, and side walls 28. Optionally a means (not shown) to alter the tilt of the squeegee (see Figs. 9 and 10) can be provided. To hold sufficient amounts of the encapsulant, the squeegee 20 is preferably provided with a reservoir for the fluid encapsulant, e.g. in the form of a trough 22. The reservoir may have an in-feed for automatically and continuously topping up the reservoir always to the same height of liquid in the reservoir. The trough may include a heater as well as sensors such as height and or temperature sensors that can be used in a control system to maintain the liquid encapsulant at constant conditions.

The relative motion between the squeegee and the substrate to be coated can include keeping the substrate stationary and moving the squeegee. Hence a means for moving the squegee installation is provided. The amount of liquid encapsulant that is a applied to the substrate (and hence the thickness of the coating) at least depends upon the gap between the edge of the doctor blade 26 and the substrate 2,6 as well as the amount of liquid reaching the blade, and its viscosity. Also in this embodiment of the present invention the encapsulant can be applied to a substrate in a thickness in the range of 50-500 microns. In this embodiment also encapsulant can be used with a viscosity of 5 to 50 Poise during the application to the substrate.

When moving upwards (and applying the encapsulant), the squeegee is provided with means for tilting so that the encapsulant can reach the substrate. Optionally, means for altering the tilt can be provided so that it can be tilted more or less to alter the amount of liquid being applied to the substrate (Fig. 11) or to maintain the amount constant.

In the embodiments described above no structure is applied to the encapsulant by the coating process. In a further embodiment a structure is provided. For example, a screen with openings (such as a mesh) can be used between the squeegee and the substrate (as in normal screen printing). Such a printing screen may be used to apply structure to the applied encapsulant. For example, this structure can have a mesh with different hole sizes which may be used to compensate for changes in height of the electronic components to be encapsulated, e.g. thicker areas in the solar matrix such as where the conductive ribbons or wires of the solar cells are located. This printing screen may be held in a static position relative to the substrate or, alternatively a small printing screen can be moved along with the doctor blade of the squeegee. This small printing plate is less than the size of the substrate, i.e. is only covering the full width but not the complete height. Such a printing screen can be used, for example for structuring the encapsulant in the direction perpendicular to the direction of movement.

If an encapsulant coating with local thickness variation is desired, the gap between the blade and the glass/back sheet may vary over the length of the blade. Such a change of thickness can e.g. be to apply less at the edges of the substrate, for example. When pressing the lay-up together, the liquid encapsulant flows so as to fill the complete module.

Means may be provided for altering the distance between the substrate and the blade. This may be an adjusting screw and may be controlled manually or automatically (an monitored using a distance sensor)

### Positioning of blade

The blade may abut on the substrate (glass) or on the base/wall the glass is supported with. In the former case, the gap between the glass or back back layer such as the back sheet (BS) and the blade may be wider near the point where the blade abuts on the glass or back back layer such as the back sheet. In this way more material will be applied there where the blade abuts the substrate (and therefore no encapsulant can be applied) so that later enough material is present to cover also the area of abutment. It may also be that when pressing the lay-up together, the liquid encapsulant will simply flow as to fill the complete module.

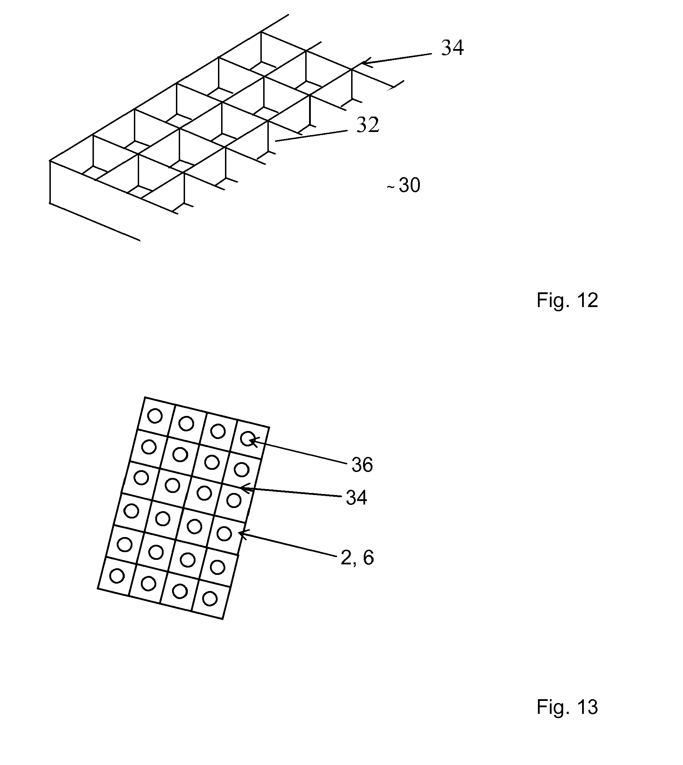

As indicated above, if a uniform thickness or a well defined thickness (even if varying) is to be obtained the substrate should be flat and it should be kept flat during the coating process. To maintain the gap between the blade of the squeegee and the substrate, the latter has to be kept as flat as possible and preferably perfectly flat. Due to the potentially large weight and size of the substrate, the means 24 for holding the substrate can be implemented as a "suction wall" 30 in accordance with an embodiment of the present invention which can be used with any of the other embodiments to hold the substrate 2 or 6. A suction wall 30 is an array of suction devices 32 or vacuum clamps that suck the substrate onto its surface (see Fig. 12). The suction wall 30 is preferably made very rigid so that it is very stable. By clamping the glass substrate 2 or the back sheet 6 to the suction wall, the substrate such as the glass or the back sheet can adjust itself and become flat. Alternatively the substrate may be attracted by electrostatic charging. This is especially suited for a back sheet that may deform under influence of the under-pressure. Electrostatic charge can be applied continuously so that the foil is attracted everywhere with the same force and therefore no local deformations will occur.

The suction wall comprises a frame 34 extending in three directions as shown schematically in Figs. 12 and 13.

Below the frame is a cover plate with vacuum holes 36. The holes can be the ends of tubing used for sucking air and applying the vacuum or it may e.g. be suction cups for example with air flow induced lower pressure using the Bernoulli principle. The substrate such as the glass or the backing sheet is placed on the frame forming chambers made up of the frame, cover plate and glass or backing sheet. The air is sucked out of the chambers making the glass or backing sheet flat.

For a more flexible substrate such as a polymeric back sheet more and smaller vacuum holes and a finer grid of the frame is preferably made. Alternatively porous materials, e.g. a flat porous ceramic can be used instead of the frame and the discrete vacuum holes.

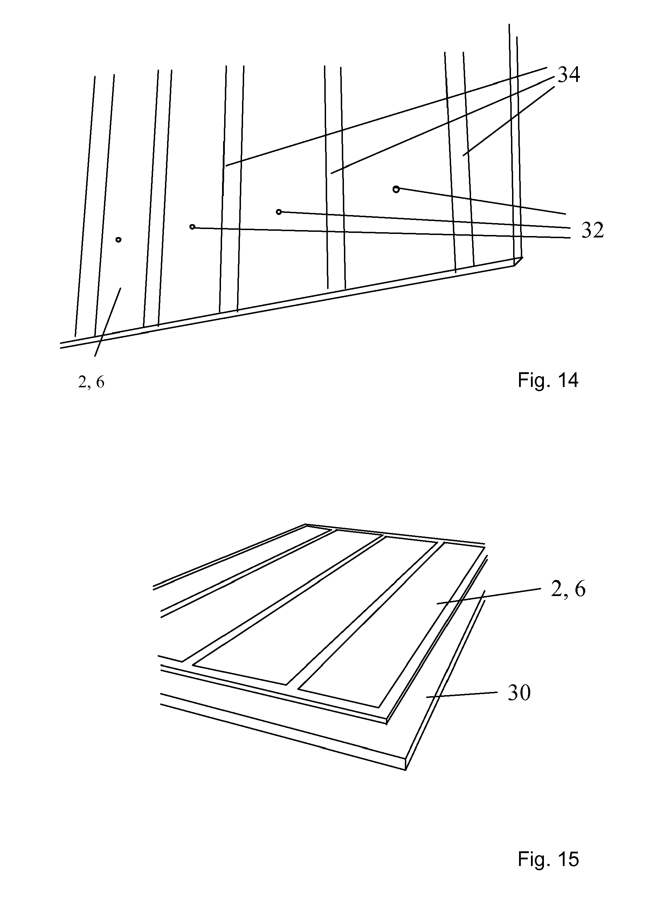

An embodiment of the suction wall 30 is shown in Fig. 14 showing the vacuum holes 36 that form suctions cups and soft rubber is included in the frame 34 where the substrate 2,6 is to touch the frame 34.

In Fig. 15 the glass plate 2 is shown installed on the frame 34 of the suction wall 30. The frame 34 comprises soft rubber stripes to form the chambers. Preferably the glass or other substrate 2,6 is held vertically to save footprint and to prevent bending under its own weight. Also the handling of glass is much easier when it is vertical.

### Reference numbers

1 - solar cell module
2 - front layer, e.g. glass
3 - active elements such as solar cells
4 - encapsulant layer
   4a - first encapsulant layer
   4b - second encapsulant layer
5 - back layer, e.g. polymer sheet
7 - heating plate
8 - membrane
9 - side wall of vacuum chamber
10 - vacuum chamber
11 - air conduits
12 - stentering frame
20 - weir or squegee
22 - reservoir ,e.g. trough
24 - means for holding substrate
26 - doctoring blade or edge
28 - side walls of trough
30 - suction wall
32 - suction device
34 - suction wall frame
36 - vacuum hole
107 - transport sheet
108 - release sheet

## Claims

1. A system for preparing elements of a solar module (1) for lamination, the solar module having a first layer (2) and an outer layer (6), the system comprising:
means (24) for holding a first layer (1) so that it is flat, and
a blade or squeegee (20) used to apply the fluid to the first layer (2), the blade defining a gap to the outer layer (6).

2. The system of claim 1 wherein the means (24) for holding is adapted to hold the first layer (2) inclined and more preferably vertically.

3. The system of claim 1 or 2 further comprising a reservoir (22) for containing and or supply for fluid encapsulant.

4. The system of any of the claims 1 to 3 wherein the first layer (2) is a glass substrate or back sheet with or without integrated electronic active devices such as solar cells (3).

5. The system of any of the previous claims wherein the means (24) for holding comprises a holding wall or frame (34) with suction means (32) or a wall or frame with electro static attraction means.

6. The system of any of the claims 3 to 5, wherein the reservoir (22) is a trough with side walls (28) and the blade (26) on one side and wherein the reservoir (22) is tiltable.

7. The system of any of the previous claims wherein the reservoir (22) includes a heater or insulation means.

8. The system of any of the previous claims further comprising means for relative motion between the first layer (2) and the blade (26).

9. The system of any of the previous claims further comprising means for holding the first layer (2) stationary relative to the holding wall or frame (34).

10. A method for laminating a solar module having a first outer layer, the method comprising:
holding the first layer (2) preferably vertically, so that it is flat, and
coating an encapsulant fluid from a reservoir (22) to the first layer (2) over a blade (26), the blade (26) defining a gap to the outer layer (2),
forming the coated first layer into a lay-up and
laminating the lay-up to form a solar module (1).

11. Method of claim 10, wherein the first layer (2) is a glass substrate or a polymer sheet with or without integrated electronic active devices such as solar cells (3).

12. The method of claim 11 or 12 further comprising:
- placing active elements on the encapsulant coating;
- placing a second outer layer (6) with encapsulant on the active elements to form a lay-up; and
- laminating the lay-up to form a solar module (1).

13. The method of any of claims 10 to 12 wherein the active elements are solar cells (3) or the first layer (2) is a glass substrate or a back sheet or the encapsulant of the second outer layer (6) is a foil.

14. The method of any of the claims 10 to 13, wherein the coating is made by relative motion between the first outer layer (2) and the blade (26), and optionally the first outer layer (2) is held stationary.

15. The method of any of the claims 10 to 14 further comprising tilting the reservoir (22) during the application of the coating.
